# FASCICULE DE BREVET EUROPEEN

(11) **EP 0 614 190 B1**
(45) Date de publication et mention de la délivrance du brevet: **19.05.1999**
(21) Numéro de dépôt: 94400201.3
(22) Date de dépôt: 31.01.1994
(51) Int. Cl.: G11C 5/00, H01L 25/065

(54) **Module de mémoire a semi-conducteur**
Halbleiterspeichermodul
Semiconductor memory module

(30) Priorité: 02.02.1993 FR 9301100
(43) Date de publication de la demande: 07.09.1994
(73) Titulaire: MATRA MARCONI SPACE FRANCE, 75116 Paris (FR)
(72) Inventeur: De Givry, Jacques, F-78350 Les Loges en Josas (FR)
(74) Mandataire: Fort, Jacques

(56) Documents cités:
- WO-A-91/00683
- US-A- 5 019 943
- PATENT ABSTRACTS OF JAPAN vol. 11, no. 148 (E-506)(2595) 14 Mai 1987 & JP-A-61 287 133 (MATSUSHITA)
- PATENT ABSTRACTS OF JAPAN vol. 8, no. 256 (E-280)(1693) 22 Novembre 1984 & JP-A-59 127 856 (NIPPON DENKI)
- IBM TECHNICAL DISCLOSURE BULLETIN. vol. 32, no. 5B , Octobre 1989 , NEW YORK US pages 227 - 228 'SELF-ALIGNING MEMORY MODULE'

## Description

L'invention concerne le domaine des dispositifs de mémorisation à grande capacité utilisés dans les systèmes informatiques.

Elle trouve une application particulièrement importante dans les enregistreurs à état solide, qui tendent à se substituer aux enregistreurs électromagnétiques du fait des limitations de ces derniers et de l'apparition de composants de mémorisation à haute intégration, dépassant 1 Mbit en statique et 4 Mbits en dynamique.

Il existe de nombreuses applications dans lesquelles l'espace occupé doit être aussi réduit que possible. Souvent, il est également souhaitable de réduire la masse pour une capacité donnée. Ce cas est notamment celui des équipements prévus pour des véhicules spatiaux et des satellites.

On a déja proposé (EP-A-0 489 643) de réduire le volume et la masse d'un dispositif de mémorisation à semi-conduteurs en empilant des composants de forme allongée dont les sorties sont localisées aux extrémités et en disposant en croix deux composants superposés. Le croisement de deux composants superposés permet d'accéder à leurs sorties pour y souder des fils de raccordement.

Mais les composants ou "puces" de mémorisation de grande capacité (4 Mbits et au-delà) disponibles ou annoncés ont souvent des plots de sortie disposés non pas aux extrémités, mais sur tout le pourtour d'une grande face ou même sur l'axe médian parallèle au grand côté d'une grande face. Et même lorsque les plots sont aux extrémités le rapport entre la longueur et la largeur de ces composants est souvent insuffisant pour que leur croisement autorise un accès facile aux plots de sortie.

On connaît également (WO-A-91 00683) un empilement de composants; dans chaque composant la majeure partie des pistes de liaison (30) sont placées ailleurs que sur la zone active, avec la conséquence d'un encombrement et d'une surface de semiconducteur importants.

L'invention vise notamment à fournir un module de mémoire à grande capacité répondant mieux que ceux antérieurement connus aux exigences de la pratique, notamment en ce qu'il autorise un empilement de plusieurs composants tout en laissant subsister la possibilité de raccordement à un support d'interconnexion. Dans ce but, l'invention propose notamment un module de mémoire suivant la revendication 1 ou 2.

Il est généralement préférable de donner au substrat une largeur telle que les plages de raccordement soient disposées au-delà de la zone contenant les circuits actifs, afin de ne pas les endommager lors de la fixation de fils souples de raccordement sur ces plages. Dans la pratique, il suffit, pour atteindre ce résultat, d'une augmentation de largeur d'environ 1mm. Cet accroissement ne modifie pas le rendement de fabrication et ne diminue que légèrement le nombre de composants que l'on peut fabriquer dans une tranche de semi-conducteurs.

Toutefois, certains modes de fixation de fils, notamment celui dit, "wedge bonding", permettent de tolérer des raccordements directement au-dessus de la zone active.

Les plages supplémentaires, s'ajoutant aux plages de raccordement reliées à des plots et réparties parmi elles, peuvent être utilisées comme relais facilitant le câblage entre les composants empilés et/ou avec le support.

L'invention sera mieux comprise à la lecture de la description qui suit de modes particuliers de réalisation, donnés à titre d'exemples non-limitatifs. La description se réfère aux dessins qui l'accompagnent, dans lesquels :
- la figure 1 est un schéma de principe montrant celle des grandes faces d'un composant de mémorisation qui porte des plots de sortie, dans un mode particulier de réalisation (l'échelle n'étant pas respectée pour plus de clarté) ;
- la figure 2 est une représentation schématique en élévation d'un module de mémoire comportant quatre composants empilés ;
- la figure 3 est un autre schéma encore, montrant, en perspective, une fraction de module ;
- la figure 4 est une vue de détail à grande échelle montrant l'utilisation possible des plages relais pour réaliser les interconnexions.

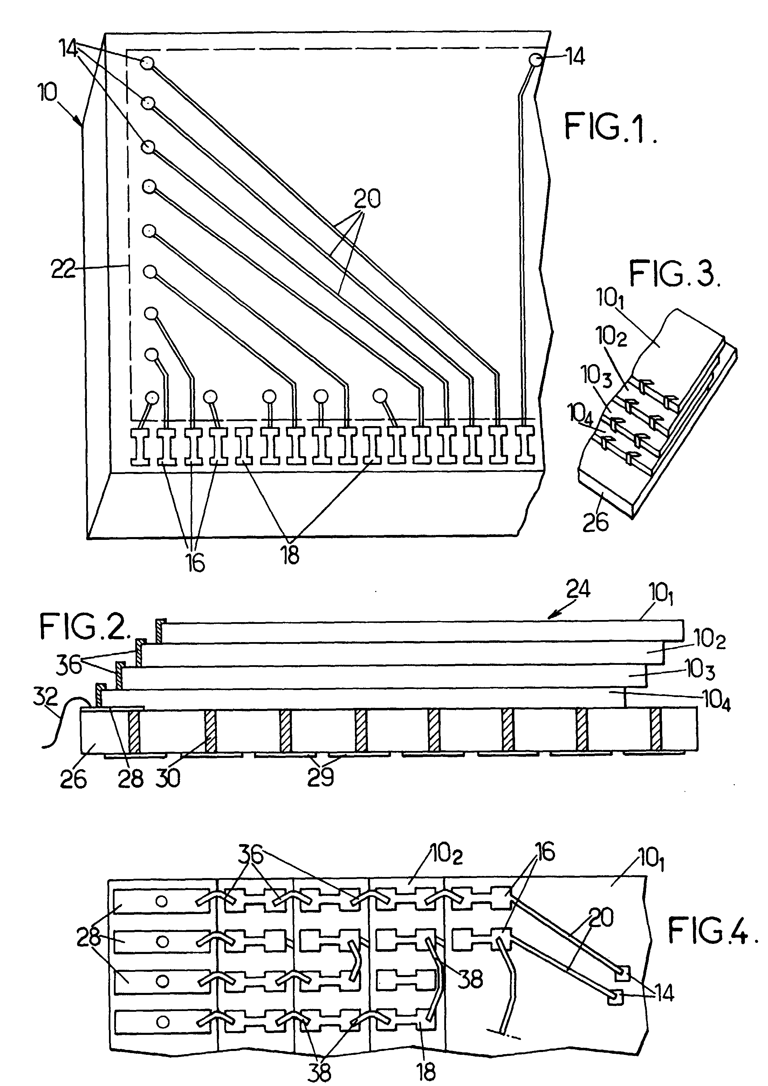

Le composant 10 dont une fraction est montrée schématiquement en figure 1 constitue une puce de mémoire de forme allongée, portant sur une grande face des plots 14 répartis sur les quatre côtés. L'invention serait également applicable au cas d'un composant ayant une autre répartition des plots de sortie, par exemple une répartition suivant celle des lignes médianes de la grande face qui est orientée dans le sens de la longueur. Les plots de sortie 14 sont reliés à des plages d'interconnexion respectives 16 réparties de façon régulière le long d'un seul des grands côtés de la face. Dans le mode de réalisation illustré, des plages supplémentaires 18, non-raccordées à des plots, sont disposées parmi les plages 16 et en alignement avec elles.

Les liaisons ou routages entre les plots 14 et les plages 16 peuvent être réalisées par des techniques bien connues, utilisées largement pour réaliser des modules multi-puces, dits MCM. Sur le silicium du composant, utilisé comme substrat, on dépose d'abord une couche d'isolation diélectrique en un matériau généralement organique, tel qu'un polyimide, puis on forme les pistes de liaison 20 elles-mêmes, habituellement par métallisation et photogravure. Il est souhaitable d'éviter de croiser les pistes si on souhaite réaliser le routage en mono-couche, de façon économique. Néanmoins un routage multicouche pourra être utilisé si nécessaire, par exemple si un plan de masse local devrait être prévu pour réduire des phénomènes parasites de diaphonie.

Dans le mode de réalisation illustré, les plages 16 et 18 sont disposées sur un bord du substrat qui est hors de la zone active, indiquée sur la figure 1 par le cadre 22 en tirets.

La longueur habituelle d'une puce de mémoire de grande capacité (typiquement 15 à 20 mm) autorise la mise en place de la quarantaine de connexions au maximum qui sont nécessaires et au surplus la mise en place d'une plage de raccordement supplémentaire 18 pour deux à cinq plages 16. Les procédés actuels de soudage de fil fin d'or ou d'aluminium (25 ou 38 µm) permettent en effet de réduire le pas de répartition à 100-150 µm.

Chacune des plages 16 et 18 représentées comporte deux renflements de fixation dont un termine une piste dans le cas des plages 16. Mais cette forme n'est pas limitative et en particulier chaque plage peut être plus longue que celles représentées et comporter plus de deux zones de connexion.

Les composants du genre décrit ci-dessus permettent de constituer des modules de mémoire en les empilant dans la même orientation, avec chaque fois un décalage suffisant pour que les plages de raccordement d'un composant débordent du composant placé au-dessus. Le module 24 montré schématiquement en figure 2 comporte un support d'interconnexion 26, généralement en alumine, et un empilement de quatre composants 10₁, 10₂, 10₃ et 10₄. Le support 26 peut porter des conducteurs 28 réalisés par technologie couche épaisse en or sur la partie latérale de la face qui reçoit le composant 10₄. Ces conducteurs 28 constituent des relais entre les composants et l'extérieur. Le composant 10₄ est en retrait par rapport au bord du substrat de façon que les conducteurs 28 soient accessibles sur une margelle comparable au décalage entre composants successifs. Le support peut également porter des conducteurs 29 sur l'autre face. Des liaisons entre les conducteurs 28, 29 de part et d'autre du support 26 peuvent être réalisés par des trous métallisés 30.

Les technologies actuelles permettent de constituer sans difficulté des conducteurs 28, d'environ 150 µm par exemple, sur la face qui reçoit le composant 10₄. Les conducteurs 29 permettent notamment de constituer des plots de test accessibles.

Les connexions du module avec l'extérieur peuvent être constituées par des fils souples 32 soudés sur les conducteurs 28. La mise en place des tronçons de fil de câblage peut s'effectuer par des procédés déjà connus, et notamment par ceux décrits dans les brevets antérieurs de la demanderesse.

Le câblage de liaison d'un composant à l'autre et du composant 10₄ au substrat peut être réalisé de façon simple par des fils isolés courts. Les entrées/sorties et les alimentations communes peuvent alors câblées en chaîne entre les composants et le support, dans le cas où les composants sont des puces mémoires. Les jonctions 36 sur la figure 4 sont des exemples d'un tel câblage en chaîne. Les entrées et sorties spécifiques, en très petit nombre, peuvent être câblées de façon simple, en évitant toute liaison directe entre les composants et l'extérieur, par utilisation des plages relais 18, comme le montrent par exemple les jonctions 38 sur la figure 4.

Bien que le matériau qui semble à l'heure actuelle le plus approprié pour le support 26 soit l'alumine ou une céramique du même genre, on peut envisager d'autres matériaux, à condition que les coefficients de dilatation thermique des composants et du support soient comparables et que le support ait une conductivité thermique suffisante pour dissiper la chaleur. On peut notamment utiliser des supports de nature organique. Les composants 10₁ ,..., 10₄ peuvent être solidarisés les uns des autres et du support 26 par une pastille de colle appliquée par sérigraphie ou au tampon ou sous forme de film sec qui garantit une épaisseur constante. Le porte-à-faux de chaque composant par rapport à celui qui se trouve au-dessous reste toujours suffisamment faible pour que le chemin d'évacuation thermique ne soit pas notablement allongé.

Le support 26 n'est pas nécessairement un petit substrat : un substrat hybride, portant d'autres composants, peut aussi être utilisé.

L'invention permet de constituer notamment des mémoires de très grande capacité. On a en particulier constitué des modules en assemblant quatre puces de mémoire vive dynamique 16 Mbits sur un support en couche épaisse, dans un encombrement inférieur à 20x15 mm. Une autre application comporte huit modules du genre montré sur les figures 2 à 4 équipés sur chaque face d'un support en céramique biface. Ces supports peuvent être complétés par des capots métalliques d'étanchéité. On peut ainsi constituer des mémoires de masse dont la capacité est d'environ 20 Mbits/g.

## Revendications

1. Module de mémoire comprenant, sur un support d'interconnexion, plusieurs composants de mémorisation ayant tous la même forme allongée, deux composants successifs étant empilés dans la même orientation, chaque composant ayant un substrat semi-conducteur de forme rectangulaire contenant des circuits actifs de mémorisation et portant des plots de sortie (14) sur une grande face qui est revêtue d'une couche d'isolement portant des pistes métalliques de liaison (20) reliant les plots de sortie (14) à des plages de raccordement (16) disposées sur ladite grande face le long d'un seul des grands côtés du substrat,
caractérisé en ce que deux composants successifs sont décalés l'un par rapport à l'autre de façon que les plages de raccordement (16,18) d'un composant débordent du composant placé au-dessus dans l'empilement et en ce que chaque substrat porte également des plages supplémentaires (18) qui s'ajoutent aux plages de raccordement (16) reliées à des plots (14) et qui sont réparties parmi elles.

2. Composant selon la revendication 1, caractérisé en ce que le substrat a une largeur telle que les plages de raccordement (16) sont disposées au-delà de la zone contenant les circuits actifs.

3. Module de mémoire comprenant, sur un support d'interconnexion (26), plusieurs composants de mémorisation ayant tous la même forme allongée, deux composants successifs étant empilés dans la même orientation, chaque composant ayant un substrat semi-conducteur de forme rectangulaire contenant des circuits actifs de mémorisation et portant des plots de.sortie (14) sur une grande face qui est revêtue d'une couche d'isolement portant des pistes métalliques de liaison (20) reliant les plots de sortie (14) à des plages de raccordement (16) disposées sur ladite grande face le long d'un seul des grands côtés du substrat, caractérisé en ce que deux composants successifs sont décalés l'un par rapport à l'autre de façon que les plages de raccordement (16,18) d'un composant débordent du composant placé au-dessus dans l'empilement et en ce que les pistes métalliques sont toutes placées au-dessus de la zone contenant les circuits actifs.

4. Composant selon la revendication 1, 2 ou 3, caractérisé en ce que les pistes métalliques de liaison sont sans croisement.

5. Module selon l'une quelconque des revendications 1 à 4, caractérisé en ce que le support d'interconnexion porte des conducteurs (28) sur la partie latérale de sa face qui reçoit l'empilement, le composant le plus bas (10₄) étant en retrait par rapport au bord.

6. Module selon la revendication 5, caractérisé en ce que le support porte également des conducteurs (29) sur la face opposée à celle qui reçoit l'empilement, des liaisons entre les conducteurs de part et d'autre du support (26) sont réalisées par des trous métallisés (30).

7. Module selon la revendication 5 ou 6, caractérisé en ce que les connexions avec l'extérieur sont constituées par des fils souples (32) soudés sur les conducteurs (28).

8. Module selon la revendication 5, 6 ou 7, caractérisé en ce que le câblage de liaison d'un composant à l'autre et du dernier composant au substrat sont réalisées par des fils électriquement isolés courts, les entrées/sorties et les alimentations communes étant câblées en chaîne entre les composants et le support.

9. Module selon la revendication 1 et l'une quelconque des revendications 5 à 8, caractérisé en ce que les entrées et sorties spécifiques sont câblées en évitant toute liaison directe entre les composants et l'extérieur, par utilisation de plages supplémentaires relais (18) non connectées à des pistes.

## Patentansprüche

1. Speichermodul, welches auf einem Zwischenverbindungsträger mehrere Speicherbauteile aufweist, die alle die gleiche längliche Formgebung aufweisen, wobei zwei aufeinanderfolgende Bauteile jeweils mit der gleichen Ausrichtung übereinandergestapelt sind, jedes Bauteil ein rechteckförmiges Halbleitersubstrat aufweist, das aktive Speicherschaltungen enthält und Ausgangsfelder (14) auf einer Hauptoberfläche trägt, die mit einer Isolierschicht beschichtet ist, die metallische Verbindungsbahnen (20) trägt, die die Ausgangsfelder (14) mit Anschlußflächen (16) verbinden, die auf der Hauptoberfläche entlang einer einzigen der Hauptseiten des Substrats angeordnet sind,
dadurch gekennzeichnet, daß zwei aufeinanderfolgende Bauteile jeweils derart zueinander versetzt sind, daß die Anschlußflächen (16, 18) eines Bauteils über das in der Stapelanordnung darüberliegend angeordnete Bauteil vorstehen, und daß jedes Substrat des weiteren zusätzliche Flächen (18) trägt, die zusätzlich zu den mit Feldern (14) verbundenen Anschlußflächen (16) vorgesehen und zwischen diese verteilt sind.

2. Bauteil nach Anspruch 1, dadurch gekennzeichnet, daß das Substrat eine solche Breite aufweist, daß die Anschlußflächen (16) jenseits der die aktiven Schaltungen enthaltenden Zone angeordnet sind.

3. Speichermodul, welches auf einem Zwischenverbindungsträger (26) mehrere Speicherbauteile aufweist, die alle die gleiche längliche Formgebung aufweisen, wobei zwei aufeinanderfolgende Bauteile jeweils mit der gleichen Ausrichtung übereinandergestapelt sind, jedes Bauteil ein rechteckförmiges Halbleitersubstrat aufweist, das aktive Speicherschaltungen enthält und Ausgangs felder (14) auf einer Hauptoberfläche trägt, die mit einer Isolierschicht beschichtet ist, die metallische Verbindungsbahnen (20) trägt, die die Ausgangsfelder (14) mit Anschlußflächen (16) verbinden, die auf der Hauptoberfläche entlang einer einzigen der Hauptseiten des Substrats angeordnet sind, dadurch gekennzeichnet, daß zwei aufeinanderfolgende Bauteile jeweils derart zueinander versetzt sind, daß die Anschlußflächen (16, 18) eines Bauteils über das in der Stapelanordnung darüber angeordnete Bauteil vorstehen, und daß die metallischen Bahnen alle über der die aktiven Schaltungen enthaltenden Zone angeordnet sind.

4. Bauteil nach Anspruch 1, 2 oder 3, dadurch gekennzeichnet, daß die metallischen Verbindungsbahnen keine Überkreuzung aufweisen.

5. Modul nach einem der Ansprüche 1 bis 4, dadurch gekennzeichnet, daß der Zwischenverbindungsträger auf dem Seitenabschnitt seiner die Stapelanordnung aufnehmenden Oberfläche Leiter (28) trägt, wobei das unterste Bauteil (10₄) vom Rand zurückspringend angeordnet ist.

6. Modul nach Anspruch 5, dadurch gekennzeichnet, daß der Träger auch auf der Oberfläche gegenüber von der die Stapelanordnung aufnehmenden Oberfläche Leiter (29) trägt, wobei Verbindungen zwischen den auf beiden Seiten des Trägers (26) befindlichen Leitern mittels metallisierter Öffnungen (30) verwirklicht sind.

7. Modul nach Anspruch 5 oder 6, dadurch gekennzeichnet, daß die Verbindungen mit der Außenseite aus biegsamen Drähten (32) bestehen, die auf die Leiter (28) gelötet sind.

8. Modul nach Anspruch 5, 6 oder 7, dadurch gekennzeichnet, daß die Verdrahtung zur Verbindung eines Bauteils mit dem anderen und des letzten Bauteils mit dem Substrat mittels kurzer, elektrisch isolierter Drähte verwirklicht ist, wobei die Eingänge/Ausgänge und die gemeinsamen Zuleitungen in Ketten- bzw. Reihenschaltung zwischen den Bauteilen und dem Träger verdrahtet sind.

9. Modul nach Anspruch 1 und einem der Ansprüche 5 bis 8, dadurch gekennzeichnet, daß die einzelnen Eingänge und Ausgänge unter Vermeidung jeglicher Direktverbindung zwischen den Bauteilen und der Außenseite durch die Verwendung von zusätzlichen Weiterverbindungsflächen (18) verdrahtet sind, die nicht mit Bahnen verbunden sind.

## Claims

1. Memory module comprising, on an interconnection support, a plurality of memory components, all having a same elongated shape, two successive components being stacked in a same angular position, each component having a rectangular semiconductor substrate containing active memory circuits and having output terminals (14) on a major surface thereof which is coated by an insulating layer carrying metal connection leads (20) connecting the output terminals (14) to connection pads (16) located on said major surface along only one of longer sides of the substrate,
characterised in that two successive components are mutually offset for the connection pads (16,18) of one component to be located beyond the component located above it in the stack and in that each substrate has additional pads (18) which are in addition to the connection pads (16) connected to terminals (14) and distributed among them.

2. Module according to claim 1, wherein said substrate has such a width that the connection pads (16) are beyond the zone which contains the active circuits.

3. Memory module comprising, on an interconnection support (26), a plurality of memory components, all having a same elongated shape, two successive components being stacked in a same angular position, each component having a rectangular semiconductor substrate containing active memory circuits and having output terminals (14) on a major surface thereof which is coated by an insulating layer carrying metal connection leads (20) connecting the output terminals (14) to connection pads (16) located on said major surface along only one of longer sides of the substrate,
characterised in that two successive components are mutually offset for the connection pads (16,18) of one component to be located beyond the component located above it in the stack and in that all metal leads are located above the zone which contains the active circuits.

4. Module according to claim 1, 2 or 3, characterised in that the metal connection leads are devoid of mutual crossing.

5. Module according to any one of claims 1-4, characterised in that the interconnection support carries conducting tracks (28) on that lateral portion of the major surface thereof which receives the stack, the lowest component (10₄) being offset with respect to the edge.

6. Module according to claim 5, characterised in that the support also carries additional conducting tracks (29) on the major surface opposed to the surface which receives the stack, and connections are formed between the conducting tracks on both sides of the support (26) via metal plated holes (30).

7. Module according to claim 5 or 6, characterised in that connections with the outside consist of flexible wires (32) soldered on the conductive tracks (28).

8. Module according to claim 5, 6 or 7, characterised in that wiring for mutually connecting the components and connecting the lowest component to the support consist of short lengths of electrically insulated wire, the input-outputs and common power supplies being wired serially between the components and the support.

9. Module according to claim 1 and any one of claims 5-8, characterised in that the specific inputs and outputs are wired while avoiding any direct connection between the components and the outside, by using relaying additional pads (18) which are connected to leads.
